# EUROPÄISCHE PATENTSCHRIFT

(11) **EP 2 890 744 B1**
(45) Veröffentlichungstag und Bekanntmachung des Hinweises auf die Patenterteilung: **17.02.2021**
(21) Anmeldenummer: 13748053.9
(22) Anmeldetag: 13.08.2013
(51) Int. Cl.: C08L 79/02, C08K 5/00, C09J 179/02, H05K 1/03

(54) **FLAMMGESCHÜTZTE BENZOXAZIN-HALTIGE ZUSAMMENSETZUNG**
FLAME-RETARDANT BENZOXAZINE-CONTAINING COMPOSITION
COMPOSITIONS IGNIFUGES CONTENANT DE LA BENZOXAZINE

(30) Priorität: 31.08.2012 DE 102012215510
(43) Veröffentlichungstag der Anmeldung: 08.07.2015
(73) Patentinhaber: Henkel AG & Co. KGaA, 40589 Düsseldorf (DE)
(72) Erfinder: BARRIAU, Emilie, Laguna, CA 92677 (US); KREILING, Stefan, 69214 Eppelheim (DE); SCHÖNFELD, Rainer, 40627 Düsseldorf (DE); DÖRING, Manfred, 76744 Wörth (DE)
(74) Vertreter: Hoffmann Eitle
(86) Internationale Anmeldenummer: PCT/EP2013/066882
(87) Internationale Veröffentlichungsnummer: WO 2014/032962

(56) Entgegenhaltungen:
- WO-A2-2011/080306
- US-A1- 2011 257 347

## Beschreibung

Die vorliegende Erfindung betrifft eine flammgeschützte polymerisierbare Zusammensetzung, die mindestens eine Benzoxazin-Verbindung und bestimmte phosphorhaltige Polymere enthält. Weitere Gegenstände der vorliegenden Erfindung sind Klebstoffe, Dichtstoffe, oder Beschichtungsmittel, welche die erfindungsgemäße polymerisierbare Zusammensetzung umfassen, sowie Polymerisationsprodukte der genannten Zusammensetzung.

Um einen ausreichenden Brandschutz gewährleisten zu können, ist es in vielen Anwendungsbereichen von entscheidender Bedeutung, dass die eingesetzten Kunststoffmaterialien flammhemmende Eigenschaften aufweisen.

Aufgrund ihrer guten inhärenten Brandsschutzeigenschaften eignen sich insbesondere Kunststoffmaterialien auf Basis von Benzoxazin-Verbindungen dazu, in sensiblen Anwendungsbereichen eingesetzt zu werden. Allerdings kann es erforderlich sein, die flammhemmenden Eigenschaften der jeweiligen Benzoxazin-basierten Materialien durch Zusatz weiterer Flammschutzmittel zu verbessern, um so ein optimales Eigenschaftsprofil zu erhalten.

In diesem Zusammenhang beschreibt die U.S.-Patentanmeldung US 2011/0257347 A1, sowie die Veröffentlichung von Hwang et al. im Journal of Applied Polymer Science, Vol. 110, 2413-2423 (2008) die Verwendung von 9,10-Dihydro-9-oxa-10-phospha-phentren-10-oxid (DOPO) oder dessen Derivaten zur Verbesserung der Flammschutzeigenschaften von Benzoxazin-basierten Harzsystemen.

Neben der Verbesserung der Brandschutzeigenschaften ist es aber von entscheidender Bedeutung, dass andere Eigenschaften der Benzoxazin-basierten Harzsysteme durch das jeweilige Flammschutzmittel nicht negativ beeinflusst werden. So ist beispielsweise von Bisphenolen bekannt, dass diese die Polymerisationstemperatur von Benzoxazinharzen absenken und deren Polymerisationsreaktion in unerwünschter Weise beeinflussen bzw. beschleunigen können.

Viele polymere Flammschutzmittel führen hingegen dazu, dass andere physikalische Eigenschaften der ausgehärteten Benzoxazinharze, wie beispielsweise deren Temperaturbeständigkeit und/oder deren bruchmechanische Eigenschaften signifikant verschlechtert werden.

Ziel der vorliegenden Erfindung war daher die Bereitstellung einer flammgeschützten, polymerisierbaren Zusammensetzung auf Benzoxazinbasis, deren Polymerisationsverhalten nicht wesentlich durch das verwendete Flammschutzmittel beeinflusst wird. Weiterhin sollte das Flammschutzmittel auch bei niedrigen Konzentrationen einen effektiven Flammschutz gewährleisten und nicht die Temperaturbeständigkeit und/oder die bruchmechanischen Eigenschaften der ausgehärteten Zusammensetzung verschlechtern.

Es wurde nun gefunden, dass bestimmte phosphorhaltige Polymere auf Basis von Polycarbonsäure(thio)estern und/oder Polycarbonsäureamiden in der Lage sind, einer Benzoxazinharzmatrix einen effektiven Flammschutz zu verleihen, wobei gute Brandschutzeigenschaften selbst bei niedrigen Additivgehalten erreicht werden. Die phosphorhaltigen Polymere beeinflussen dabei das Polymerisationsverhalten der jeweiligen Zusammensetzungen nicht wesentlich. Weiterhin bleiben die bruchmechanischen Eigenschaften und/oder die Temperaturbeständigkeit der gehärteten Zusammensetzung weitestgehend erhalten oder werden sogar verbessert.

Ein erster Gegenstand der vorliegenden Erfindung ist daher eine polymerisierbare Zusammensetzung, enthaltend
a) mindestens eine Benzoxazin-Verbindung und
b) mindestens ein phosphorhaltiges Polymer ausgewählt aus Polycarbonsäure(thio)estern oder Polycarbonsäureamiden, wobei das phosphorhaltige Polymer mindestens ein Strukturelement der allgemeinen Formel (I) umfasst, 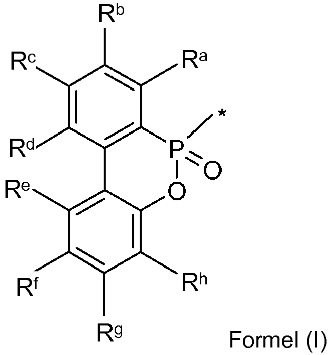 wobei R^{a}, R^{b}, R^{c}, R^{d}, R^{e}, R^{f}, R^{g} und R^{h} unabhängig voneinander ausgewählt werden aus Wasserstoff, Alkyl, Aryl, Alkoxy, Aryloxy, Aralkyl, Halogen, Cyanid, Thiol, Amin, Carboxyl oder Acyl.

Die polymerisierbaren Zusammensetzungen der vorliegenden Erfindung eignen sich im besonderen Maße zur Herstellung von Klebstoffen, Dichtstoffen oder Beschichtungsmitteln, sowie zur Herstellung von Verbundwerkstoffen, die eine Schicht oder ein Bündel von Fasern, wie beispielsweise Kohlefasern, umfassen.

Daher sind Klebstoffe, Dichtstoffe oder Beschichtungsmittel, welche die erfindungsgemäße polymerisierbare Zusammensetzung umfassen, ebenso Gegenstand der vorliegenden Erfindung, wie das Polymerisationsprodukt der jeweiligen erfindungsgemäßen Zusammensetzung, wobei das genannte Polymerisationsprodukt eine Schicht oder ein Bündel von Fasern, wie beispielsweise Kohlefasern umfassen kann.

Ein weiterer Gegenstand der vorliegenden Erfindung ist ein elektronisches Bauteil, welches die erfindungsgemäße polymerisierbare Zusammensetzung oder deren Polymerisationsprodukt umfasst.

Ebenfalls Gegenstand der vorliegenden Erfindung ist die Verwendung eines oder mehrerer der vorgenannten phosphorhaltigen Polymere als Flammschutzmittel für Benzoxazin-Verbindungen oder als Flammschutzmittel für deren Polymerisationsprodukte.

Die Benzoxazin-Verbindung der vorliegenden Erfindung ist ein Monomer, Oligomer oder Polymer, das zumindest eine Benzoxazingruppe umfasst. Bevorzugte Monomere können bis zu vier Benzoxazingruppen aufweisen. Es können sowohl einzelne Monomere als auch Mischungen von zwei oder mehr Monomeren verwendet werden.

Im Folgenden sind einige Benzoxazin-Verbindungen aufgeführt, die bis zu vier Benzoxazingruppen umfassen.

Geeignete Benzoxazin-Verbindungen werden vorzugsweise durch Formel (B-I) beschrieben, 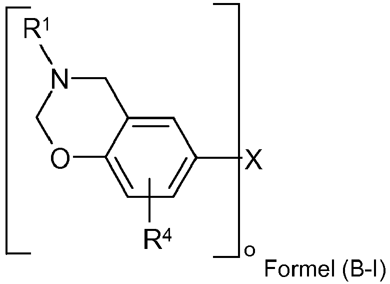 wobei o eine ganze Zahl zwischen 1 und 4 ist, X ausgewählt wird aus der Gruppe bestehend aus Alkyl (für o = 1), Alkylen (für o = 2 bis 4), Sauerstoff (für o = 2), Thiol (für o = 1), Schwefel (für o = 2), Sulfoxid (für o = 2), Sulfon (für o = 2) und einer direkten, kovalenten Bindung (für o = 2), R¹ ausgewählt wird aus der Gruppe bestehend aus Wasserstoff, Alkyl, Alkenyl und Aryl und R⁴ ausgewählt wird aus der Gruppe bestehend aus Wasserstoff, Halogen, Alkyl und Alkenyl, oder R⁴ ein divalenter Rest ist, der aus der Benzoxazin-Struktur eine entsprechende Naphthoxazin-Struktur macht.

Besonders bevorzugte Strukturen gemäß Formel (B-I) werden durch Formel (B-II) repräsentiert, 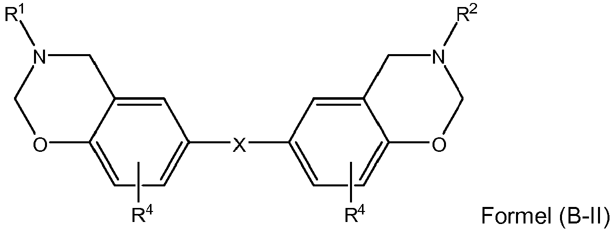 wobei X ausgewählt wird aus der Gruppe bestehend aus CH₂, C(CH₃)₂, C=O, O, S, S=O, O=S=O und einer direkten, kovalenten Bindung, R¹ und R² gleich oder verschieden sind und jeweils ausgewählt werden aus der Gruppe bestehend aus Wasserstoff, Alkyl, insbesondere Methyl, Ethyl, n-Propyl, i-Propyl, n-Butyl oder i-Butyl, Alkenyl, insbesondere Allyl, und Aryl und die Substituenten R⁴ gleich oder verschieden sind und jeweils ausgewählt werden aus der Gruppe bestehend aus Wasserstoff, Halogen, Alkyl und Alkenyl, oder R⁴ jeweils ein divalenter Rest ist, der aus der Benzoxazin-Struktur eine entsprechende Naphthoxazin-Struktur macht.

Bevorzugte Benzoxazin-Verbindungen gemäß Formel (B-II) sind beispielsweise Benzoxazin-Verbindungen gemäß Formel (B-III) bis (B-VI), 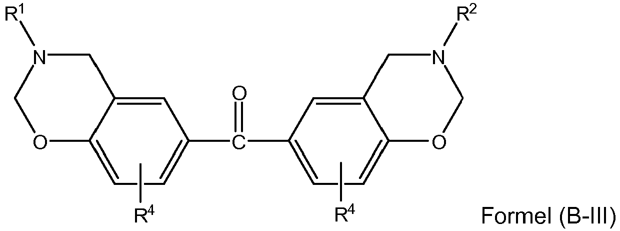 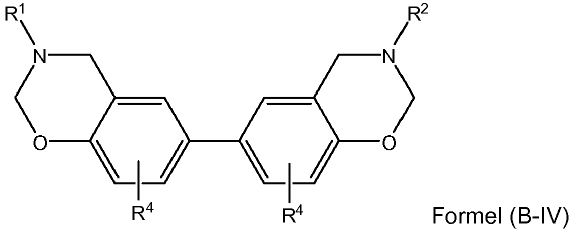 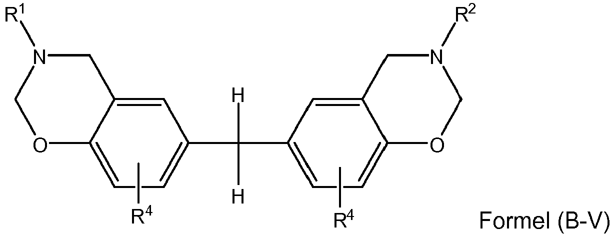 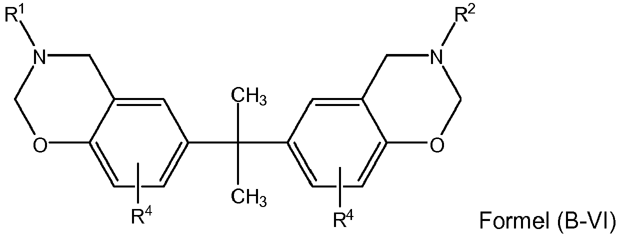 wobei R¹, R² und R⁴ wie oben definiert sind.

Bevorzugte Benzoxazin-Verbindungen sind weiterhin Verbindungen der allgemeinen Formel (B-VII), 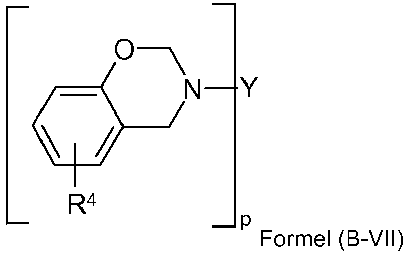 wobei p = 2 ist und Y ausgewählt wird aus der Gruppe bestehend aus Biphenyl, Diphenylmethan, Diphenylisopropan, Diphenylsulfid, Diphenylsulfoxid, Diphenylsulfon, Diphenylketon und R⁴ wie oben definiert ist.

Ebenfalls bevorzugte Benzoxazin-Verbindungen sind weiterhin Verbindungen der allgemeinen Formel (B-VIII) bis (B-X), 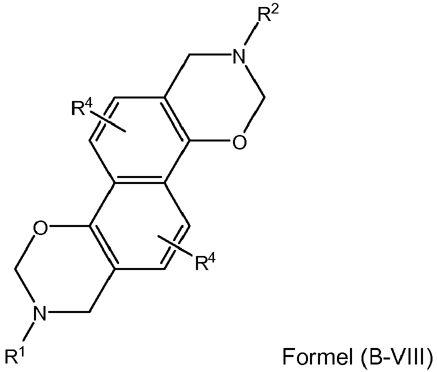 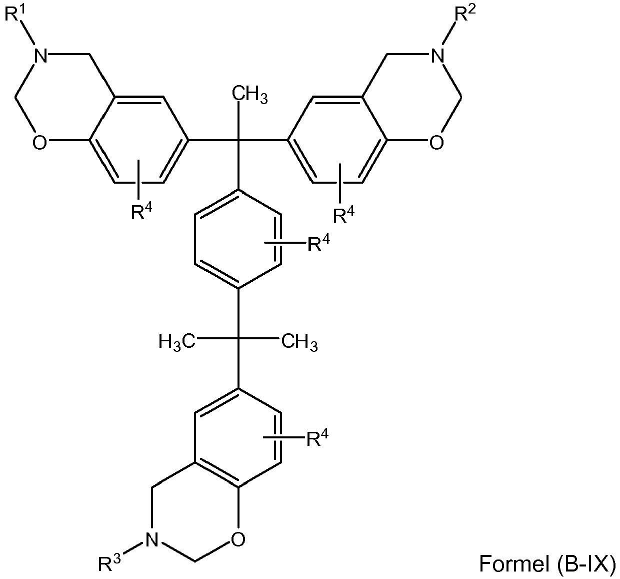 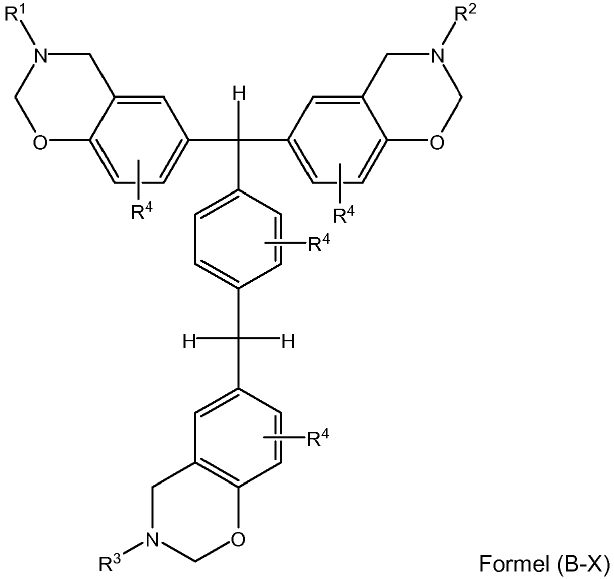 wobei R¹, R² und R⁴ wie oben definiert sind und R³ wie R¹ oder R² definiert ist.

Geeignete Benzoxazin-Verbindungen im Sinne der vorliegenden Erfindung sind beispielsweise die folgenden Verbindungen:

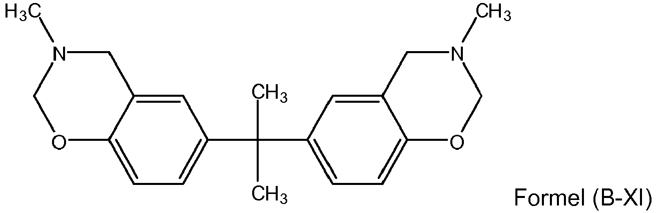

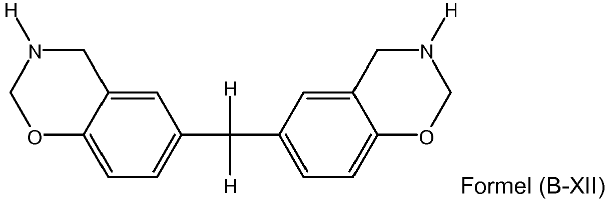

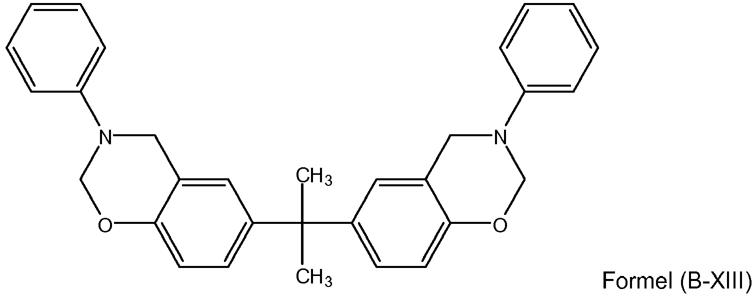

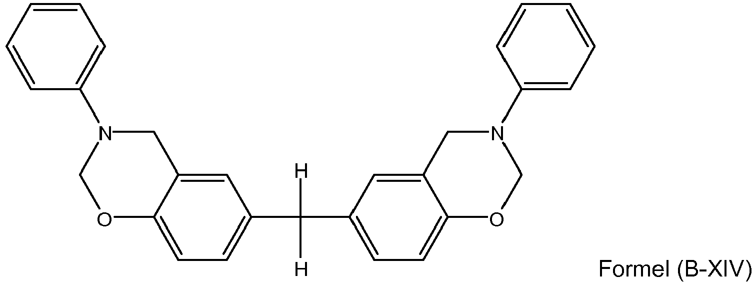

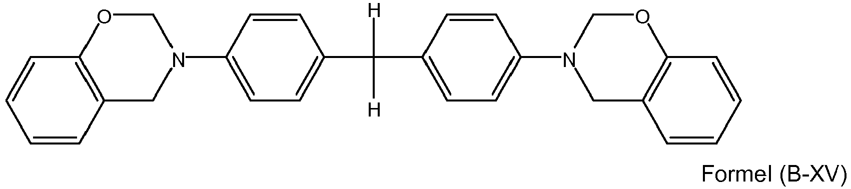

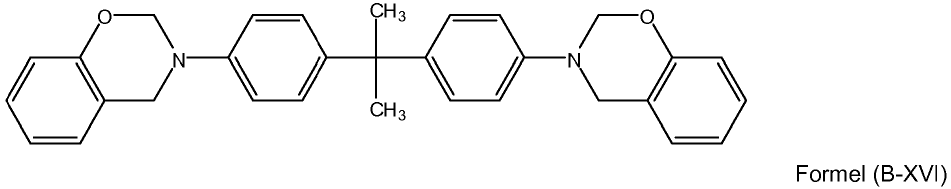

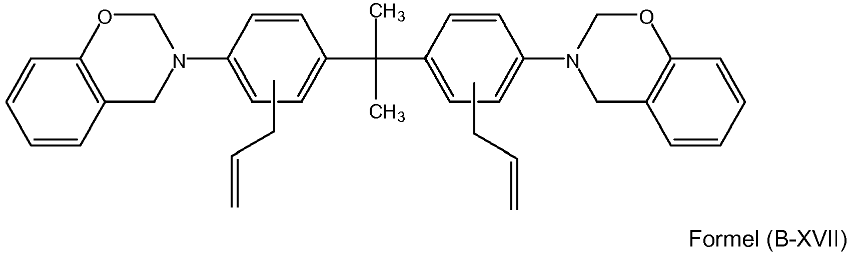

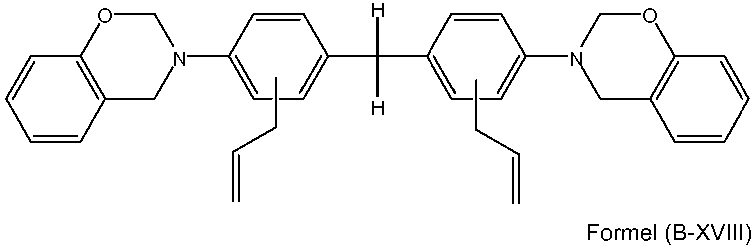

Eine weitere Benzoxazin-Verbindung, die im Rahmen der vorliegenden Erfindung verwendet werden kann, wird ausgewählt aus Verbindungen der Formel (B-XIX), 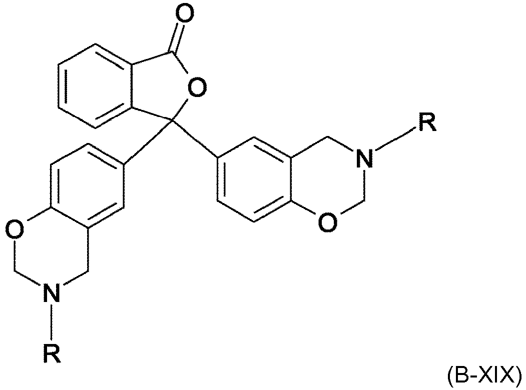 wobei jedes R in Formel (B-XIX) unabhängig voneinander ausgewählt wird aus Allyl, Aryl, C₁-C₈ Alkyl und C₃-C₈ Cycloalkyl. Die vorgenannten Gruppen können substituiert oder unsubstituiert vorliegen, wobei geeignete Substituenten beispielsweise ausgewählt werden aus Amino, Allyl und C₁-C₈ Alkyl. Vorzugsweise sind alle Reste R in Formel (B-XIX) identisch, wobei R insbesondere für eine Phenylgruppe steht.

Benzoxazin-Verbindungen im Sinne der vorliegenden Erfindung sind kommerziell erhältlich und werden u.a. von Huntsman Advanced Materials; Georgia-Pacific Resins, Inc. und Shikoku Chemicals Corporation, Chiba, Japan vertrieben.

Ungeachtet dessen können die Benzoxazin-Verbindungen der vorliegenden Erfindung auch durch Umsetzung einer phenolischen Verbindung, etwa Bisphenol A, Bisphenol F, Bisphenol S oder Thiophenol mit einem Aldehyd, etwa Formaldehyd, in Gegenwart eines primären Alkyl- oder Arylamins erhalten werden. Geeignete Herstellverfahren werden beispielsweise im US-Patent US 5,543,516, insbesondere in den Beispielen 1 bis 19 in den Spalten 10 bis 14 offenbart, wobei die Reaktionszeit der entsprechenden Umsetzung je nach Konzentration, Reaktivität und Reaktionstemperatur von einigen Minuten bis zu einigen Stunden dauern kann. Weitere Herstellungsmöglichkeiten der Benzoxazin-Verbindungen der vorliegenden Erfindung können den US-Patenten US 4,607,091, US 5,021,484 und US 5,200,452 und der internationalen Patentanmeldung WO 2006/035021 A1 entnommen werden.

Die erfindungsgemäße polymerisierbare Zusammensetzung kann nur eine Benzoxazin-Verbindung oder eine Mischung verschiedener Benzoxazin-Verbindungen enthalten.
Der Anteil der Benzoxazin-Verbindung an der Gesamtmenge der erfindungsgemäßen polymerisierbaren Zusammensetzung beträgt vorzugsweise 20 bis 99,5 Gew.-%, besonders bevorzugt 30 bis 90 Gew.-% und überaus bevorzugt von 60 bis 80 Gew.-%.
Unter dem oben genannten Anteil der Benzoxazin-Verbindung wird der Gesamtanteil aller in der erfindungsgemäßen polymerisierbaren Zusammensetzung enthaltenen Benzoxazin-Verbindungen verstanden.

Die erfindungsgemäße polymerisierbare Zusammensetzung enthält weiterhin mindestens ein phosphorhaltiges Polymer als Flammschutzmittel, das ausgewählt wird aus Polycarbonsäure(thio)estern oder Polycarbonsäureamiden, wobei das phosphorhaltige Polymer mindestens ein Strukturelement der allgemeinen Formel (I) umfasst, 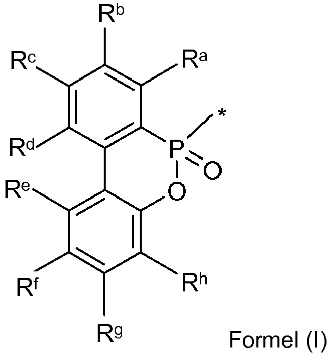 wobei R^{a}, R^{b}, R^{c}, R^{d}, R^{e}, R^{f}, R^{g} und R^{h} unabhängig voneinander ausgewählt werden aus Wasserstoff, Alkyl, Aryl, Alkoxy, Aryloxy, Aralkyl, Halogen, Cyanid, Thiol, Amin, Carboxyl oder Acyl. Insbesondere ist es bevorzugt, dass mindestens sechs der Reste R^{a} bis R^{h} für Wasserstoff stehen, wobei besonders bevorzugt jeder der Reste R^{a}, R^{b}, R^{c}, R^{d}, R^{e}, R^{f}, R^{g} und R^{h} für Wasserstoff steht.

Unter einem "phosphorhaltigem Polymer" wird im Sinne der vorliegenden Erfindung eine Verbindung verstanden, die mindestens ein Phosphoratom aufweist und aus mindestens zwei Monomereinheiten, vorzugsweise mindestens zehn Monomereinheiten und überaus bevorzugt mindestens zwanzig Monomereinheiten aufgebaut ist.

Unter der Bezeichnung "Polycarbonsäure(thio)ester" wird im Sinne der vorliegenden Erfindung sowohl ein Polycarbonsäureester als auch ein Polycarbonsäurethioester verstanden.

Der Begriff "Polycarbonsäureester" bezeichnet im Sinne der vorliegenden Erfindung ein Polymer mit Esterfunktionen in der Hauptkette, das beispielsweise in einer Polykondensationsreaktion durch Umsetzung einer Polycarbonsäure mit einem Polyol erhalten werden kann.

Der Begriff "Polycarbonsäurethioester" bezeichnet im Sinne der vorliegenden Erfindung ein Polymer mit Thioesterfunktionen in der Hauptkette, das beispielsweise in einer Polykondensationsreaktion durch Umsetzung einer Polycarbonsäure mit einem Polythiol erhalten werden kann.

Der Begriff "Polycarbonsäureamid" bezeichnet im Sinne der vorliegenden Erfindung ein Polymer mit Amidfunktionen in der Hauptkette, das beispielsweise in einer Polykondensationsreaktion durch Umsetzung einer Polycarbonsäure mit einem Polyamin erhalten werden kann.

Zur Optimierung des Polymerisationsverhaltens der erfindungsgemäßen polymerisierbaren Zusammensetzung und/oder zur Verbesserung der bruchmechanischen Eigenschaften des erfindungsgemäßen Polymerisationsproduktes kann es vorteilhaft sein, phosphorhaltige Polymere zu verwenden, die über eine oder mehrere endständige funktionelle Gruppen verfügen, die unabhängig voneinander ausgewählt werden aus Carboxylgruppen, Hydroxylgruppen, Amingruppen, Thiolgruppen, Phosphinsäuregruppen oder Phoshonsäuregruppen. Phosphorhaltige Polymere, die eine oder mehrere endständige Hydroxylgruppen tragen, sind im Sinne der vorliegenden Erfindung besonders bevorzugt. Überaus bevorzugt sind phosphorhaltige Polymere, die als endständige funktionelle Gruppen ausschließlich Hydroxylgruppen aufweisen.

In einer Ausführungsform der vorliegenden Erfindung umfasst das phosphorhaltige Polymer eine oder mehrere Struktureinheiten der allgemeinen Formel (II), 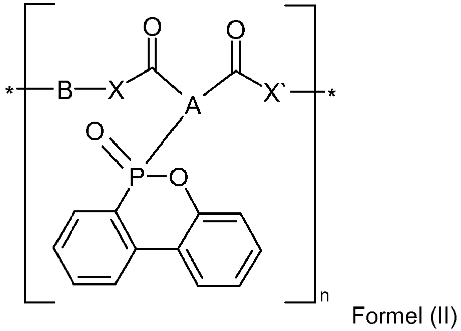 wobei n eine ganze Zahl von 2 bis 10000 ist, X und X' unabhängig voneinander ausgewählt werden aus -O-, -S- oder-NH-, A eine trivalente Verbindungsgruppe ist, die 1 bis 100 C-Atome umfasst und B eine divalente Verbindungsgruppe ist, die 2 bis 100 C-Atome umfasst.

Die divalente Verbindungsgruppe B ist vorzugsweise eine lineare oder verzweigte Gruppe, die ausgewählt wird aus Alkylengruppen, Polyoxyalkylengruppen, Arylengruppen oder aus deren beliebigen Kombinationen.

Besonders bevorzugte phosphorhaltige Polymere der vorliegenden Erfindung sind Verbindungen der allgemeinen Formel (III), 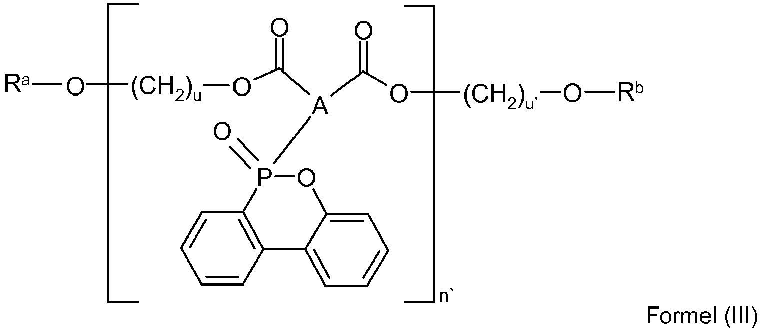 wobei n' eine ganze Zahl von 2 bis 1000 ist, u und u' unabhängig voneinander für eine ganze Zahl von 1 bis 10, vorzugsweise von 2 bis 4 stehen, A eine trivalente Verbindungsgruppe ist, die 1 bis 100 C-Atome umfasst und R^{a} und R^{b} unabhängig voneinander ausgewählt werden aus Wasserstoff, Alkyl oder Acyl. Besonders bevorzugt stehen R^{a} und R^{b} für Wasserstoff.

Bei der trivalenten Verbindungsgruppe A aus Formel (II) und (III) handelt es sich vorzugsweise um eine verzweigte aliphatische Gruppe, die vorzugsweise 2 bis 5 C-Atome, insbesondere 3 C-Atome aufweist.

Das zahlenmittlere Molekulargewicht (Mₙ) des phosphorhaltigen Polymers ist vorzugsweise größer als etwa 20000 g/mol, wobei phosphorhaltige Polymere mit einem zahlenmittleren Molekulargewicht (Mₙ) von 25000 g/mol bis 100000 g/mol aufgrund der guten Kompatibilität und der effizienten Flammschutzeigenschaften besonders bevorzugt sind. Sofern nicht anders vermerkt, wird das zahlenmittlere Molekulargewicht im Rahmen der vorliegenden Erfindung mittels Gelpermeationschromatographie (GPC) unter Verwendung eines Polystyrolstandards bestimmt.

Der Phosphorgehalt des erfindungsgemäß eingesetzten phosphorhaltigen Polymers kann in einem breiten Bereich variiert werden. Zur Erzielung optimaler Flammschutzeigenschaften beträgt der Phosphorgehalt, bezogen auf die Gesamtmenge des phosphorhaltigen Polymers, vorzugsweise 5 bis 12 Gew.-%.

Aufgrund der hohen Effektivität des erfindungsgemäß eingesetzten phosphorhaltigen Polymers können sehr gute Flammschutzeigenschaften selbst bei niedrigen Phosphorgehalten realisiert werden, so dass der Gesamtphosphorgehalt der erfindungsgemäßen polymerisierbaren Zusammensetzung vorzugsweise zwischen 0,01 und 1,5 Gew.-% liegt.

Um neben einer guten Kompatibilität zur Benzoxazinharzmatrix auch gute bruchmechanischen Eigenschaften und/oder eine gute Temperaturbeständigkeit zu erreichen, ist es für die vorliegende Erfindung von entscheidender Bedeutung, dass das phosphorhaltige Polymer ausgewählt wird aus Polycarbonsäure(thio)estern oder Polycarbonsäureamiden. Insbesondere ist es vorteilhaft, dass das erfindungsgemäß eingesetzte phosphorhaltige Polymer ein Polycarbonsäureester ist, da mit Hilfe dieser Polymere eine besonders gute Temperaturbeständigkeit und/oder gute bruchmechanische Eigenschaften realisiert werden können.

Im Sinne der vorliegenden Erfindung können die bruchmechanischen Eigenschaften durch Ermittlung des Spannungsintensitätsfaktors K1c (Critical Stress Intensity Factor) und der Bruchenergie G1c (Critical Energy Release Rate) bestimmt werden. Der kritische Spannungsintensitätsfaktor K1c (Critical Stress Intensity Factor) und die Bruchenergie G1c (Critical Energy Release Rate) können gemäß ASTM D5045-96 unter Verwendung des so genannten "single etch notch bending (SENB)" bestimmt werden, wobei jeweils ein Probenkörper der Größe 56 mm x 12.7 mm x 3.2 mm verwendet wird.

Geeignete phosphorhaltige Polymere sind kommerziell erhältlich und werden beispielsweise von der Firma Schill+Seilacher AG unter dem Handelsnamen Ukanol FR 80 vertrieben.

Die phosphorhaltigen Polymere können auch nach jedem geeigneten Verfahren hergestellt werden. Ein mögliches Herstellungsverfahren beruht auf der Umsetzung von 9,10-Dihydro-9-oxa-10-phospha-phenanthren-10-oxid oder dessen Derivaten mit ungesättigte Verbindungen aus der Gruppe der mehrwertigen Carbonsäuren oder deren Anhydriden. Das so gebildete Additionsprodukt kann mit entsprechenden Polyolen, Polyaminen und/oder Polythiolen in einer Polykondensationsreaktion zu den entsprechenden phosphorhaltigen Polycarbonsäure(thio)estern und/oder Polycarbonsäureamiden der vorliegenden Erfindung umgesetzt werden. Geeignete Polyole sind beispielsweise aliphatische Diole, die vorzugsweise ausgewählt werden aus Monoethylenglykol, Diethylenglykol, Propylenglykol, 1,3-Propandiol 1,3-Butandiol, 1,4-Butandiol, Hexandiol, 1,10-Decandiol oder aus deren Mischungen. Beispiele für geeignete Herstellungsverfahren können der europäischen Patentanmeldung EP 2 090 618 A2 in den Absätzen [0015] bis [0020] und der internationalen Patentanmeldung WO 2009/109347 A1 entnommen werden.

Die erfindungsgemäße polymerisierbare Zusammensetzung kann ein phosphorhaltiges Polymer oder eine Mischung mehrerer der vorgenannten phosphorhaltigen Polymere enthalten.

Der Anteil des phosphorhaltigen Polymers an der Gesamtmenge der erfindungsgemäßen polymerisierbaren Zusammensetzung beträgt vorzugsweise 0,01 bis 20 Gew.-%, besonders bevorzugt 0,1 bis 10 Gew.-% und überaus bevorzugt 1 bis 7,5 Gew.-%. Unter dem vorgenannten Anteil des phosphorhaltigen Polymers wird im Sinne der vorliegenden der Gesamtanteil aller in der erfindungsgemäßen polymerisierbaren Zusammensetzung enthaltenen phosphorhaltigen Polymere verstanden.

In einer Ausführungsform umfasst die polymerisierbare Zusammensetzung als polymerisierbare Harzkomponente nur eine oder mehrere Benzoxazin-Verbindungen. Für bestimmte Anwendungszwecke kann es aber vorteilhaft sein, dass die polymerisierbare Zusammensetzung zusätzlich weitere polymerisierbare Harzkomponenten umfasst. Geeignete Verbindungen können beispielsweise ausgewählt werden aus der Gruppe der Epoxidharze, Polyurethanharze, Polyesterharze, Polyamidharze oder Phenolharze oder aus deren beliebigen Mischungen.

Unter einem "Epoxidharz" wird im Rahmen der vorliegenden Erfindung eine HarzZusammensetzung verstanden, die auf der Basis von Epoxidverbindungen oder epoxidhaltigen Verbindungen gebildet wird.

In einer bevorzugten Ausführungsform der Erfindung können die Epoxidverbindungen oder epoxidhaltigen Verbindungen des Epoxidharzsystems der polymerisierbaren Zubereitung sowohl oligomere als auch monomere Epoxidverbindungen sowie Epoxide vom polymeren Typ umfassen und können aliphatische, cycloaliphatische, aromatische oder heterocyclische Verbindungen darstellen.
Geeignete Epoxidharze im Rahmen der vorliegenden Erfindung sind beispielsweise vorzugsweise ausgewählt aus Epoxidharzen vom Bisphenol-A-Typ, Epoxidharzen vom Bisphenol-S-Typ, Epoxidharzen vom Bisphenol-F-Typ, Epoxidharzen vom Phenol-Novolak-Typ, Epoxidharzen vom Cresol-Novolak-Typ, epoxidierten Produkten zahlreicher Dicyclopentadien-modifizierter Phenolharze, erhältlich durch Umsetzung von Dicyclopentadien mit zahlreichen Phenolen, epoxidierte Produkte von 2,2',6,6'-Tetramethylbiphenol, aromatische Epoxidharze wie Epoxidharze mit Naphthalin-Grundgerüst und Epoxidharze mit Fluoren-Grundgerüst, aliphatische Epoxidharze, alicyclische Epoxidharze wie 3,4-Epoxycyclohexylmethyl-3,4-epoxycyclohexancarboxylat und Bis(3,4-epoxycyclohexyl)adipat und Epoxidharzen mit mindestens einem Heteroring.

Insbesondere umfassen die Epoxidharze Octadecylenoxid, Styroloxid, Vinylcyclohexenoxid, Glycidol, Vinylcyclohexendioxid, 3,4-Epoxycyclohexylmethyl-3,4-epoxycyclohexen-carboxylat, 3,4-Epoxy-6-methylcyclohexylmethyl-3,4-epoxy-6-methyl-cyclohexencarboxylat, Bis(3,4-epoxy-6-methylcyclohexylmethyl)adipat, Bis(2,3-epoxy-cyclopentyl)ether, aliphatisches, Dipentendioxid, epoxidiertes Polybutadien (z.B. Krasol Produkte von Sartomer), Epoxidfunktionalität enthaltendes Siliconharz, flammhemmende Epoxidharze (z.B. "DER-580", Bis(3,4-epoxycyclohexyl)adipat, 2-(3,4-Epoxycyclohexyl-5,5-spiro-3,4-epoxy)cyclohexan-meta-dioxan, Vinylcyclohexenmonoxid und 2-Epoxyhexadecan.

Besonders bevorzugte Epoxidharze im Sinne der vorliegenden Erfindung sind cycloaliphatische Epoxidharze, die kommerziell beispielsweise unter dem Handelsnamen CY179 (Huntsman), ACHWL CER 4221 (Achiewell, LLC) oder Cyracure 6105/6110 (DOW Chemical) erhältlich sind.

Die erfindungsgemäße polymerisierbare Zusammensetzung kann nur ein Epoxidharz oder eine Mischung mehrerer der vorgenannten Epoxidharze enthalten.

Sofern vorhanden, beträgt der Anteil des Epoxidharzes an der Gesamtmenge der polymerisierbaren Zusammensetzung vorzugsweise 5 bis 50 Gew.-%, besonders bevorzugt 10 bis 30 Gew.-% und überaus bevorzugt 15 bis 25 Gew.-%. Unter dem vorgenannten Anteil des Epoxidharzes wird im Sinne der vorliegenden Erfindung der Gesamtanteil aller in der erfindungsgemäßen polymerisierbaren Zusammensetzung enthaltenen Epoxidharze verstanden.

Die erfindungsgemäße polymerisierbare Zusammensetzung kann neben den oben beschriebenen Komponenten auch ein oder mehrere Additive enthalten, die vorzugsweise ausgewählt werden aus Füllstoffen, Weichmachern, Reaktivverdünnern, Schlagzähmodifizierungsmittel, Rheologiehilfsmittel, Netzmittel, Alterungsschutzmittel, Stabilisatoren, Farbpigmente oder deren Mischungen

Bevorzugte erfindungsgemäße Zusammensetzungen umfassen oder bestehen aus, bezogen auf die Gesamtmenge der polymerisierbaren Zusammensetzung:
a) 50 bis 99,5 Gew.-% mindestens einer Benzoxazin-Verbindung,
b) 0,01 bis 20 Gew.-% mindestens eines phosphorhaltigen Polymers der vorliegenden Erfindung,
c) 0 bis 20 Gew.-% mindestens eines Epoxidharzes, insbesondere mindestens eines cycloaliphatischen Epoxidharzes und
d) 0 bis 20 Gew.-% mindestens eines Additivs.

Insbesondere ist es vorteilhaft, dass die erfindungsgemäße polymerisierbare Zusammensetzung im Wesentlichen halogenfrei ist. Der Begriff "im Wesentlichen halogenfrei" bedeutet im Sinne der vorliegenden Erfindung, dass der Anteil von Halogenatomen an der Gesamtmenge der erfindungsgemäßen polymerisierbaren Zusammensetzung weniger als etwa 0,1 Gew.-%, vorzugsweise weiniger als etwa 0,01 Gew.-% und insbesondere weniger als etwa 0,001 Gew.-% beträgt. Geringe Restmengen an Halogen-haltigen Verbindungen können beispielsweise durch das verwendete Lösungsmittel oder durch den eingesetzten Initiator in die polymerisierbare Zusammensetzung eingebracht werden. Obwohl in diesen Zusammensetzungen Halogen-Restmengen vorhanden sind, beeinflussen diese geringen Restmengen nicht die physikalischen Eigenschaften der fertigen Zusammensetzungen, beispielsweise im Hinblick auf deren Flammhemmeigenschaften, Abschälfestigkeit und dielektrischen Eigenschaften.
Insbesondere ist es vorteilhaft, wenn die polymerisierbare Zusammensetzung der vorliegenden Erfindung vollkommen frei von halogenhaltigen Flammschutzmitteln ist.

Ein weiterer Gegenstand der vorliegenden Erfindung ist das Polymerisationsprodukt der erfindungsgemäßen polymerisierbaren Zusammensetzung.

Im Rahmen der Polymerisation der erfindungsgemäßen polymerisierbaren Zusammensetzung findet eine Polymerisation der enthaltenen Benzoxazin-Verbindungen statt. Diese kann bei erhöhten Temperaturen nach einem selbst-initiierenden Mechanismus (thermische Polymerisation) oder durch Zugabe von kationischen Initiatoren erfolgen.

Geeignete kationische Initiatoren sind beispielsweise Lewissäuren oder andere kationische Initiatoren, wie beispielsweise Metallhalogenide, Organometall-Reagenzien, wie Metalloporphyrine, Methyltosylate, Methyltriflate oder Trifluorsulfonsäuren. Ebenso können basische Reagenzien verwendet werden, um die Polymerisation der enthaltenen Benzoxazin-Verbindung(en) zu initiieren. Geeignete basische Reagenzien können beispielsweise ausgewählt werden aus Imidazol oder Imidazolderivaten.

Vorzugsweise erfolgt die thermische Polymerisation der erfindungsgemäßen polymerisierbaren Zusammensetzung bei Temperaturen von 150 bis 300°C, insbesondere bei Temperaturen von 160 bis 220°C. Durch die Verwendung der oben genannten Initiatoren und/oder anderer Reagenzien kann die Polymerisationstemperatur auch niedriger liegen.

In einer bevorzugten Ausführungsform der Erfindung umbettet das erfindungsgemäße Polymerisationsprodukt eine Schicht oder ein Bündel von Fasern, wobei die Fasern vor der Härtung (Polymerisation) mit der erfindungsgemäßen polymerisierbaren Zusammensetzung behandelt werden. Durch die anschließende Härtung wird ein faserverstärkter Verbundwerkstoff erhalten.

Daher ist ein weiterer Gegenstand der vorliegenden Erfindung ein Verfahren zur Herstellung eines Polymerisationsproduktes der erfindungsgemäßen polymerisierbaren Zusammensetzung, wobei die genannte Zusammensetzung eine Schicht oder ein Bündel von Fasern umbettet und die Fasern vor der Härtung mit der erfindungsgemäßen polymerisierbaren Zusammensetzung behandelt werden.

Das erfindungsgemäße Verfahren umfasst die Schritte:
a) Bereitstellung einer Schicht oder eines Bündels von Fasern;
b) Bereitstellung der erfindungsgemäßen polymerisierbaren Zusammensetzung;
c) Erzeugung eines Verbundsystems durch Behandlung einer Schicht oder eines Bündels von Fasern mit der erfindungsgemäßen polymerisierbaren Zusammensetzung;
d) Gegebenenfalls Entfernung einer überschüssigen Menge der polymerisierbaren Zusammensetzung vom Verbundsystem; und
e) Durchführung einer Polymerisationsreaktion, indem das Verbundsystem erhöhter Temperatur und vorzugsweise einem erhöhten Druck ausgesetzt wird.

Unter dem Begriff "erhöhte Temperatur" sind im Sinne der vorliegenden Erfindung vorzugsweise Temperaturen von 40°C bis 300°C, besonders bevorzugt von 50°C bis 280°C und überaus bevorzugt von 80°C bis 250°C zu verstehen.

Die genannten Fasern werden vorzugsweise ausgewählt aus Glasfasern, Kohlefasern, Aramidfasern, Borfasern, Aluminiumoxidfasern oder Siliciumcarbidfasern. Es können zwei oder mehr dieser Fasertypen als Gemisch verwendet werden. Um ein Produkt mit geringerem Gewicht und höherer Haltbarkeit herzustellen, ist die Verwendung von Kohlefasern besonders bevorzugt.

Die Schicht oder das Bündel von Fasern sind im Sinne der vorliegenden Erfindung nicht auf eine bestimmte Form oder Anordnung festgelegt und so können z. B. lange Fasern, die in eine Richtung parallel gelegt sind, Towgarne, Gewebe (Stoff), Matten, Strickgewebe oder Borten verwendet werden.

Die nach dem genannten Verfahren hergestellten faserverstärkten Verbundwerkstoffe können auf Grund ihres geringen Gewichts und hohen strukturellen Festigkeit beispielsweise im Flugzeugbau oder in der Automobilindustrie verwendet werden.

Bei der Herstellung der faserverstärkten Verbundwerkstoffe der vorliegenden Erfindung kann generell auf jedes bekannte Herstellungsverfahren aus dem Stand der Technik zurückgegriffen werden.

In einem weit verbreiteten Verfahren zur Herstellung von faserverstärkten Verbundwerkstoffen werden Prepregs oder Towpregs aus Fasern (Verstärkungsfasern) und ungehärteten polymerisierbaren Zusammensetzungen als Zwischenprodukt hergestellt, die dann handlaminiert und wärmegehärtet werden.

Im Harzinjektionsverfahren (RTM, resin transfer molding) wird eine flüssige wärmehärtbare polymerisierbare Zusammensetzung ggf. unter Druck in ein in einer Form befindliches Verstärkungsfasersubstrat eingespritzt und dieses dann wärmegehärtet, um einen faserverstärkten Verbundwerkstoff zu erhalten. Alternativ dazu kann ein in einer offenen Form befindliches Verstärkungsfasersubstrat mit einem Vakuumbeutel abgedeckt werden, so dass beim Einspritzen der polymerisierbaren Zusammensetzung abgesaugt werden kann. Letzteres Verfahren wird auch als vakuumunterstütztes Harzinjektionsverfahren (VaRTM) bezeichnet.

Ein weiterer Gegenstand der vorliegenden Erfindung ist ein Klebstoff, Dichtstoff oder Beschichtungsmittel, welches die erfindungsgemäße polymerisierbare Zusammensetzung umfasst.

Aufgrund der vorteilhaften Kombination aus guten Brandschutzeigenschaften mit einer geringen Schrumpfungstendenz und einer hohen thermischen Belastbarkeit, können die erfindungsgemäße Zusammensetzung sowie deren Polymerisationsprodukte in besonders vorteilhafter Weise zur Herstellung elektronsicher Bauteile verwendet werden. Ein weiterer Gegenstand der vorliegenden Erfindung ist daher ein elektronisches Bauteil, das die erfindungsgemäße polymerisierbare Zusammensetzung oder deren Polymerisationsprodukt umfasst. Geeignete elektronische Bauteile können beispielsweise ausgewählt werden aus integrierten Schaltungen, Halbleitereinheiten, Solarzellen, Solarmodulen oder Leuchtdioden.

### Beispiele

Als Benzoxazin-Verbindung (Box) wurde eine Mischung zweier Benzoxazin-Verbindungen verwendet, die bezogen auf die Gesamtmenge der Mischung zu 60 Gew.-% aus Box-I und zu 40 Gew.-% aus Box-II bestand.

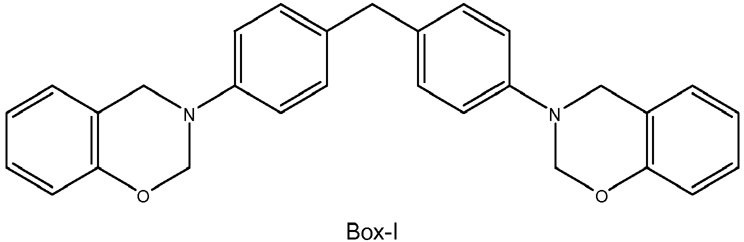

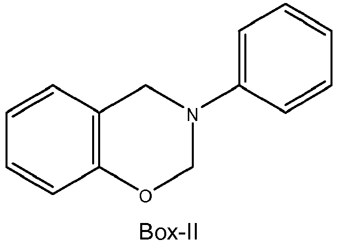

Die Herstellung der polymerisierbaren Zusammensetzung erfolgte, indem in einer geeigneten Vorrichtung die oben gezeigten Benzoxazin-Verbindungen Box-I und Box-II und das cycloaliphatische Epoxidharz CER 4221 der Firma Achiewell Inc. vorgelegt wurden. Unter Rühren wurde die entsprechende Menge des phosphorhaltigen Polyesters Ukanol FR80 der Firma Schill+Seilacher AG und ggf. weitere Additive bzw. Initiatoren zugesetzt. Die Mischung wurde unter Rühren im Vakuum (< 10 mbar) bei 80°C für 15 bis 30 Minuten homogenisiert und anschließend in geschlossenen Behältnissen gelagert.

Tabelle 1 zeigt die Anteile der einzelnen Bestandteile an den polymerisierbaren Zusammensetzungen, jeweils bezogen auf die Gesamtmenge der polymerisierbaren Zusammensetzung.

**Tabelle I: Polymerisierbare Zusammensetzungen**

| Polymerisierbare Zusammensetzung | Box-I+Box-II [Gew.-%] | CER 4221 [Gew.-%] | Ukanol FR80 [Gew.-%] |
|---|---|---|---|
| | | | |
| 1 (Ref.) | 75 | 25 | - |
| 2 | 73,12 | 24,38 | 2,50 |
| 3 | 71,25 | 23,75 | 5,00 |

Die polymerisierbaren Zusammensetzungen wurden in einem Auoklaven bei 180°C innerhalb von 90 min thermisch ausgehärtet. Anschließend wurden die gehärteten Proben (Polymerisationsprodukte) auf 22°C abgekühlt und mit den folgenden Methoden charakterisiert.

Die Glasübergangstemperatur (T_{g}) wurde durch Dynamisch-Mechanische Thermo-Analyse (DMTA) bestimmt, wobei die jeweilige Glasübergangstemperatur aus dem Maximalwert des Verlustmodul vs. Temperatur Diagramms erhalten wurde.

Die Ermittlung der Brandschutzklasse erfolgte gemäß des UL-94 Vertical Burning Tests unter Verwendung von gehärteten Proben (Polymerisationsprodukte) mit einer Dicke von 4 mm. Im Rahmen des UL-94 Vertical Burning Tests wird Stoffen mit besonders guten Brandschutzeigenschaften die Klassifikation V0 zugeordnet.

Die Glasübergangstemperaturen (Tg) der Polymerisationsprodukte der polymerisierbaren Zusammensetzungen und deren Brandschutzeigenschaften sind in Tabelle 2 dargestellt.

**Tabelle 2: Glasübergangstemperatur und Brandschutzverhalten**

| Zusammensetzung | Tg [°C] | UL-94 Klassifikation |
|---|---|---|
| | | |
| 1 (Ref.) | 202 | >V1 |
| 2 | 205 | V0-V1 |
| 3 | 204 | V0 |

Tabelle 2 zeigt, dass eine sehr gute Brandschutzklassifikation bereits bei äußerst niedrigen Gehalten (2,5 Gew.-%) an phosphorhaltigen Polymeren erreicht werden kann. Darüber hinaus bewirken die erfindungsgemäß verwendeten phosphorhaltigen Polymere nicht eine unerwünschte Absenkung der Glasübergangstemperatur (T_{g}) der ausgehärteten Benzoxazinharzmatrix. Zusammenfassend kann somit festgestellt werden, dass die phosphorhaltigen Polymere der vorliegenden Erfindung effektive Flammschutzmittel für Benzoxazin-Verbindungen darstellen, welche die physikalischen Eigenschaften der ausgehärteten Polymerisationsprodukte nicht in negativer Weise beeinflussen.

## Patentansprüche

1. Polymerisierbare Zusammensetzung, enthaltend
a) mindestens eine Benzoxazin-Verbindung und
b) mindestens ein phosphorhaltiges Polymer ausgewählt aus Polycarbonsäure(thio)estern oder Polycarbonsäureamiden, wobei das phosphorhaltige Polymer mindestens ein Strukturelement der allgemeinen Formel (I) umfasst, 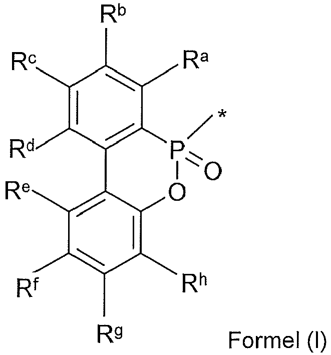 wobei R^{a}, R^{b}, R^{c}, R^{d}, R^{e}, R^{f}, R^{g} und R^{h} unabhängig voneinander ausgewählt werden aus Wasserstoff, Alkyl, Aryl, Alkoxy, Aryloxy, Aralkyl, Halogen, Cyanid, Thiol, Amin, Carboxyl oder Acyl.

2. Polymerisierbare Zusammensetzung nach Anspruch 1, **dadurch gekennzeichnet, dass** das phosphorhaltige Polymer über eine oder mehrere endständige funktionelle Gruppen verfügt, die unabhängig voneinander ausgewählt werden aus Carboxylgruppen, Hydroxylgruppen, Amingruppen, Thiolgruppen, Phosphinsäuregruppen oder Phoshonsäuregruppen.

3. Polymerisierbare Zusammensetzung nach Ansprüche 1 oder 2, **dadurch gekennzeichnet, dass** das phosphorhaltige Polymer eine oder mehrere Struktureinheiten der allgemeinen Formel (II) umfasst, 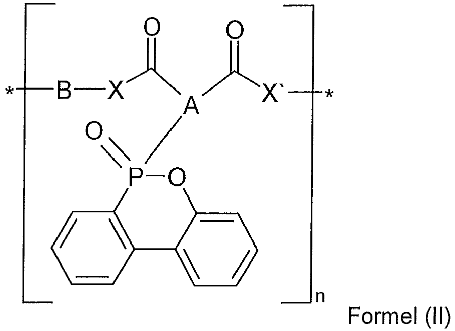 wobei n eine ganze Zahl von 2 bis 10000 ist, X und X' unabhängig voneinander ausgewählt werden aus -O-, -S- oder -NH-, A eine trivalente Verbindungsgruppe ist, die 1 bis 100 C-Atome umfasst und B eine divalente Verbindungsgruppe ist, die 2 bis 100 C-Atome umfasst.

4. Polymerisierbare Zusammensetzung nach Anspruch 3, **dadurch gekennzeichnet, dass** B in Formel (II) eine lineare oder verzweigte Verbindungsgruppe ist, die ausgewählt wird aus Alkylengruppen, Polyoxyalkylengruppen, Arylengruppen oder aus deren beliebigen Kombinationen.

5. Polymerisierbare Zusammensetzung nach mindestens einem der Ansprüche 1 bis 4, **dadurch gekennzeichnet, dass** das phosphorhaltige Polymer eine Verbindung der allgemeinen Formel (III) ist, 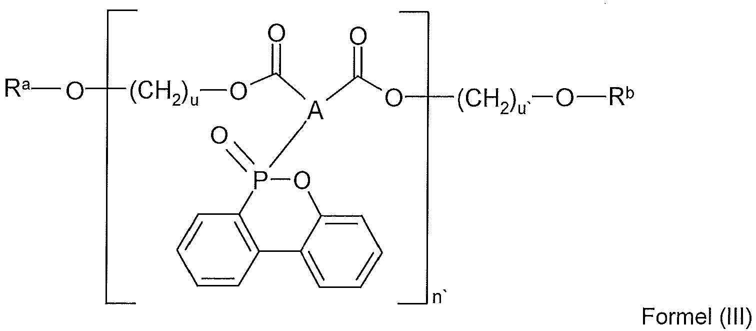 wobei n' eine ganze Zahl von 2 bis 1000 ist, u und u' unabhängig voneinander für eine ganze Zahl von 1 bis 10 stehen, A eine trivalente Verbindungsgruppe ist, die 1 bis 100 C-Atome umfasst und R^{a} und R^{b} unabhängig voneinander ausgewählt werden aus Wasserstoff, Alkyl oder Acyl.

6. Polymerisierbare Zusammensetzung nach mindestens einem der Ansprüchen 1 bis 5, **dadurch gekennzeichnet, dass** das phosphorhaltige Polymer ein zahlenmittleres Molekulargewicht (Mₙ) von 25000 g/mol bis 100000 g/mol aufweist.

7. Polymerisierbare Zusammensetzung nach mindestens einem der Ansprüchen 1 bis 6, **dadurch gekennzeichnet, dass** der Phosphorgehalt des phosphorhaltigen Polymers 5 bis 12 Gew.-% beträgt.

8. Polymerisierbare Zusammensetzung nach mindestens einem der Ansprüchen 1 bis 7, **dadurch gekennzeichnet, dass** der Gesamtphosphorgehalt der polymerisierbaren Zusammensetzung zwischen 0,01 und 1,5 Gew.-% liegt.

9. Polymerisierbare Zusammensetzung nach mindestens einem der Ansprüche 1 bis 8, **dadurch gekennzeichnet, dass** das phosphorhaltiges Polymer ein Polycarbonsäureester ist.

10. Polymerisierbare Zusammensetzung nach mindestens einem der Ansprüchen 1 bis 9, **dadurch gekennzeichnet, dass**, jeweils bezogen auf die Gesamtmenge der polymerisierbaren Zusammensetzung,
- der Anteil der polymerisierbaren Benzoxazin-Verbindung 20 bis 99,5 Gew.-% und/oder
- der Anteil des phosphorhaltigen Polymers 0,1 bis 10 Gew.-% beträgt.

11. Polymerisationsprodukt der polymerisierbaren Zusammensetzung nach mindestens einem der Ansprüche 1 bis 10.

12. Polymerisationsprodukt nach Anspruch 11, **dadurch gekennzeichnet, dass** das Polymerisationsprodukt eine Schicht oder ein Bündel von Fasern umbettet, wobei die Schicht oder das Bündel von Fasern vor der Härtung mit einer polymerisierbaren Zusammensetzung nach mindestens einem der Ansprüche 1 bis 10 behandelt werden.

13. Verfahren zur Herstellung eines Polymerisationsproduktes nach Anspruch 12, umfassend die Schritte:
a) Bereitstellung einer Schicht oder eines Bündels von Fasern;
b) Bereitstellung einer polymerisierbaren Zusammensetzung nach mindestens einem der Ansprüche 1 bis 10;
c) Erzeugung eines Verbundsystems durch Behandlung einer Schicht oder eines Bündels von Fasern mit der polymerisierbaren Zusammensetzung;
d) Gegebenenfalls Entfernung einer überschüssigen Menge der polymerisierbaren Zusammensetzung vom Verbundsystem; und
e) Durchführung einer Polymerisationsreaktion, indem das Verbundsystem erhöhter Temperatur und vorzugsweise einem erhöhten Druck ausgesetzt wird.

14. Klebstoff, Dichtstoff oder Beschichtungsmittel, umfassend eine polymerisierbare Zusammensetzung nach mindestens einem der Ansprüche 1 bis 10.

15. Elektronisches Bauteil, umfassend eine polymerisierbare Zusammensetzung nach mindestens einem der Ansprüche 1 bis 10 oder ein Polymerisationsprodukt gemäß Anspruch 11.

## Claims

1. Polymerisable composition containing
(a) at least one benzoxazine compound and
(b) at least one phosphorus-containing polymer selected from polycarboxylic acid (thio)esters or polycarboxylic acid amides, wherein the phosphorus-containing polymer comprises at least one structural element of the general formula (I), 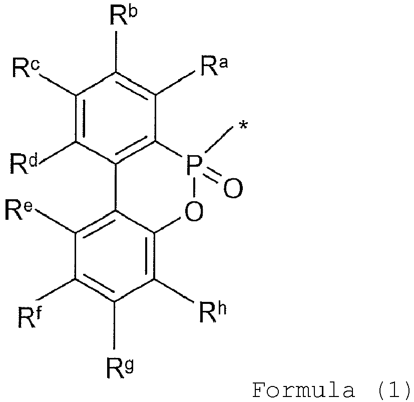 wherein R^{a}, R^{b}, R^{c}, R^{d}, R^{e}, R^{f}, R^{g} and R^{h} are selected, independently of one another, from hydrogen, alkyl, aryl, alkoxy, aryloxy, aralkyl, halogen, cyanide, thiol, amine, carboxyl or acyl.

2. Polymerisable composition according to claim 1, **characterised in that** the phosphorus-containing polymer has one or more terminal functional groups which are selected, independently of one another, from carboxyl groups, hydroxyl groups, amine groups, thiol groups, phosphinic acid groups or phosphonic acid groups.

3. Polymerisable composition according to claims 1 or 2, **characterised in that** the phosphorus-containing polymer comprises one or more structural units of the general formula (II), 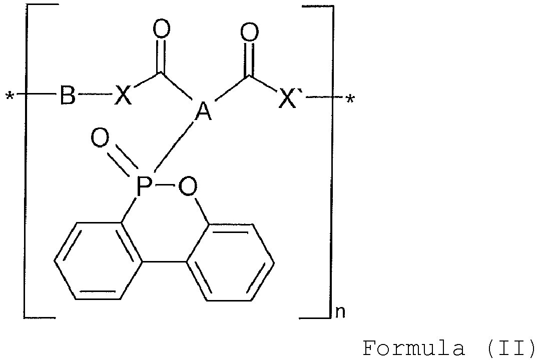 wherein n is an integer from 2 to 10,000, X and X' are selected, independently of one another, from -0-, -S- or - NH-, A is a trivalent linking group comprising 1 to 100 carbon atoms and B is a divalent linking group comprising 2 to 100 carbon atoms.

4. Polymerisable composition according to claim 3, **characterised in that** B in formula (II) is a linear or branched linking group which is selected from alkylene groups, polyoxyalkylene groups, arylene groups or any combinations thereof.

5. Polymerisable composition according to at least one of the claims 1 to 4, **characterised in that** the phosphorus-containing polymer is a compound of the general formula (III), 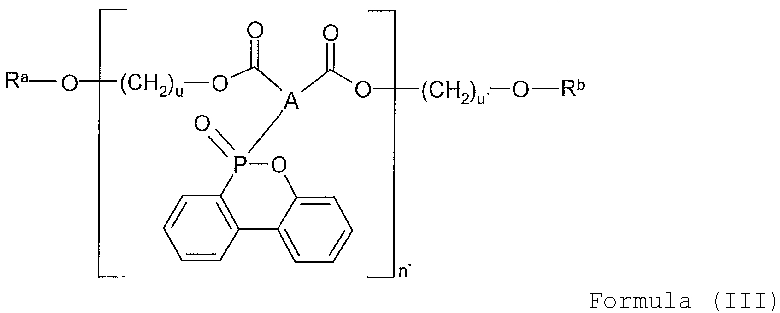 wherein n' is an integer from 2 to 1000, u and u' represent, independently of one another, an integer from 1 to 10, A is a trivalent linking group comprising 1 to 100 carbon atoms and R^{a} and R^{b} are selected, independently of one another, from hydrogen, alkyl or acyl.

6. Polymerisable composition according to at least one of the claims 1 to 5, **characterised in that** the phosphorus-containing polymer has a number average molecular weight (Mₙ) of 25,000 g/mol to 100,000 g/mol.

7. Polymerisable composition according to at least one of the claims 1 to 6, **characterised in that** the phosphorus content of the phosphorus-containing polymer amounts to 5 to 12 % by weight.

8. Polymerisable composition according to at least one of the claims 1 to 7, **characterised in that** the total phosphorus content of the polymerisable composition lies between 0.01 and 1.5 % by weight.

9. Polymerisable composition according to at least one of the claims 1 to 8, **characterised in that** the phosphorus-containing polymer is a polycarboxylic acid ester.

10. Polymerisable composition according to at least one of the claims 1 to 9, **characterised in that**, in each case based on the total quantity of the polymerisable composition,
- the proportion of the polymerisable benzoxazine compound is 20 to 99.5 % by weight and/or
- the proportion of the phosphorus-containing polymer is 0.1 to 10 % by weight.

11. Polymerisation product of the polymerisable composition according to at least one of the claims 1 to 10.

12. Polymerisation product according to claim 11, **characterised in that** the polymerisation product embeds a layer or a bundle of fibres, wherein the layer or the bundle of fibres are treated before curing with a polymerisable composition according to at least one of the claims 1 to 10.

13. Method for producing a polymerisation product according to claim 12 comprising the steps:
(a) providing a layer or bundle of fibres;
(b) providing a polymerisable composition according to at least one of the claims 1 to 10;
(c) creating a composite system by treating a layer or bundle of fibres with the polymerisable composition;
(d) If necessary removing a surplus quantity of the polymerisable composition from the composite system; and
(e) carrying out a polymerisation reaction in that the composite system is subjected to increased temperature and preferably an increased pressure.

14. Adhesive, sealant or coating agent comprising a polymerisable composition according to at least one of the claims 1 to 10.

15. Electronic component comprising a polymerisable composition according to at least one of the claims 1 to 10 or a polymerisation product according to claim 11.

## Revendications

1. Composition polymérisable, contenant
a) au moins un composé de benzoxazine et
b) au moins un polymère contenant du phosphore sélectionné parmi les (thio)esters d'acides polycarboxyliques ou les amides d'acides polycarboxyliques, dans laquelle le polymère contenant du phosphore comprend au moins un élément structurel de la formule générale (I), 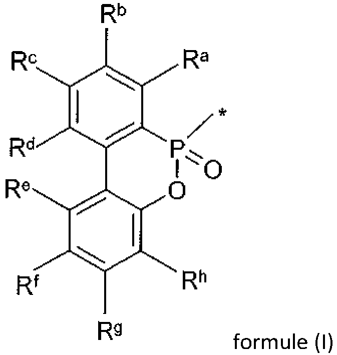 dans laquelle R^{a}, R^{b}, R^{c}, R^{d}, R^{e}, R^{f}, R^{g} et R^{h} sont sélectionnés indépendamment les uns des autres parmi hydrogène, alkyle, aryle, alcoxy, aryloxy, aralkyle, halogène, cyanure, thiol, amine, carboxyle ou acyle.

2. Composition polymérisable selon la revendication 1, **caractérisée en ce que** le polymère contenant du phosphore dispose d'un ou plusieurs groupes fonctionnels terminaux qui sont sélectionnés indépendamment les uns des autres parmi les groupes carboxyle, les groupes hydroxyle, les groupes amine, les groupes thiol, les groupes acides phosphiniques ou les groupes acides phoshoniques.

3. Composition polymérisable selon les revendications 1 ou 2, **caractérisée en ce que** le polymère contenant du phosphore comprend une ou plusieurs unités structurelles de la formule générale (II), 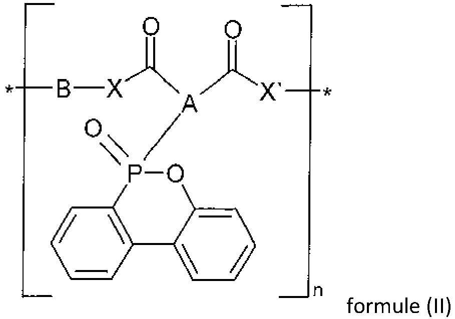 dans laquelle n est un nombre entier de 2 à 10 000, X et X' sont sélectionnés indépendamment l'un de l'autre parmi -O-, -S- ou -NH-, A est un groupe de composé trivalent qui comprend 1 à 100 atomes C, et B est un groupe de composé divalent qui comprend 2 à 100 atomes C.

4. Composition polymérisable selon la revendication 3, **caractérisée en ce que** B dans la formule (II) est un groupe de composé linéaire ou ramifié qui est sélectionné parmi les groupes alkylènes, les groupes polyoxyalkylènes, les groupes arylènes ou parmi les quelconques combinaisons de ceux-ci.

5. Composition polymérisable selon au moins l'une quelconque des revendications 1 à 4, **caractérisée en ce que** le polymère contenant du phosphore est un composé de la formule générale (III), 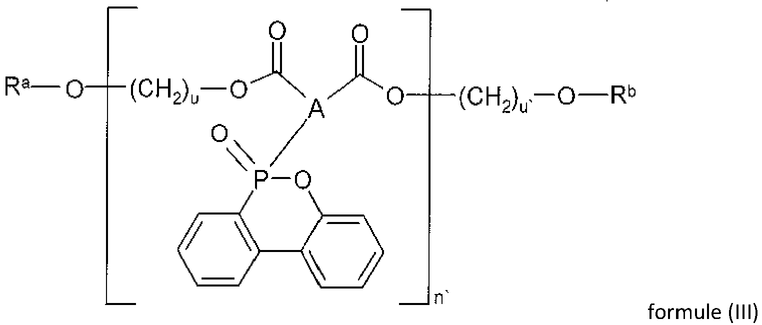 dans laquelle n' est un nombre entier de 2 à 1000, u et u' représentent indépendamment l'un de l'autre un nombre entier de 1 à 10, A est un groupe de composé trivalent qui comprend 1 à 100 atomes C, et R^{a} et R^{b} sont sélectionnés indépendamment l'un de l'autre parmi hydrogène, alkyle ou acyle.

6. Composition polymérisable selon au moins l'une quelconque des revendications 1 à 5, **caractérisée en ce que** le polymère contenant du phosphore présente un poids moléculaire moyen en nombre (Mₙ) de 25 000 g/mol à 100 000 g/mol.

7. Composition polymérisable selon au moins l'une quelconque des revendications 1 à 6, **caractérisée en ce que** la teneur en phosphore du polymère contenant du phosphore est de 5 à 12 % en poids.

8. Composition polymérisable selon au moins l'une quelconque des revendications 1 à 7, **caractérisée en ce que** la teneur totale en phosphore de la composition polymérisable est comprise entre 0,01 et 1,5 % en poids.

9. Composition polymérisable selon au moins l'une quelconque des revendications 1 à 8, **caractérisée en ce que** le polymère contenant du phosphore est un ester d'acide polycarboxylique.

10. Composition polymérisable selon au moins l'une quelconque des revendications 1 à 9, **caractérisée en ce que**, respectivement par rapport à la quantité totale de la composition polymérisable,
- la part du composé de benzoxazine polymérisable est de 20 à 99,5 % en poids et/ou
- la part du polymère contenant du phosphore est de 0,1 à 10 % en poids.

11. Produit de polymérisation de la composition polymérisable selon au moins l'une quelconque des revendications 1 à 10.

12. Produit de polymérisation selon la revendication 11, **caractérisé en ce que** le produit de polymérisation enrobe une couche ou un faisceau de fibres, dans lequel la couche ou le faisceau de fibres est traité(e) avec une composition polymérisable selon au moins l'une quelconque des revendications 1 à 10 avant le durcissement.

13. Procédé de fabrication d'un produit de polymérisation selon la revendication 12, comprenant les étapes de :
a) fourniture d'une couche ou d'un faisceau de fibres ;
b) fourniture d'une composition polymérisable selon au moins l'une quelconque des revendications 1 à 10 ;
c) génération d'un système composite par traitement d'une couche ou d'un faisceau de fibres avec la composition polymérisable ;
d) le cas échéant, retrait d'une quantité excédentaire de la composition polymérisable du système composite ; et
e) réalisation d'une réaction de polymérisation en soumettant le système composite à une température élevée et, de préférence, à une pression élevée.

14. Matière adhésive, matière d'étanchéité ou moyen de revêtement, comprenant une composition polymérisable selon au moins l'une quelconque des revendications 1 à 10.

15. Composant électronique, comprenant une composition polymérisable selon au moins l'une quelconque des revendications 1 à 10, ou un produit de polymérisation selon la revendication 11.
